# EUROPÄISCHE PATENTSCHRIFT

(11) **EP 0 399 091 B1**
(45) Veröffentlichungstag und Bekanntmachung des Hinweises auf die Patenterteilung: **15.03.1995**
(21) Anmeldenummer: 89115789.3
(22) Anmeldetag: 26.08.1989
(51) Int. Cl.: H05K 7/14

(54) **Vorrichtung zum elektrisch leitenden Verbinden einer Leiterplatte mit einer Modulschiene eines Baugruppenträgers**
Device for connecting a circuit board to a modular rack rail
Dispositif pour relier électriquement une plaque de circuit avec un rail modulaire d'un rack

(30) Priorität: 26.05.1989 DE 8906491 U
(43) Veröffentlichungstag der Anmeldung: 28.11.1990
(73) Patentinhaber: Rittal-Werk Rudolf Loh GmbH & Co. KG, 35745 Herborn (DE)
(72) Erfinder: Keens, Gary, Roborough Plymouth PL6 6AU (GB); Fursier, Roger, Saltash Cornwall PL12 4QQ (GB)
(74) Vertreter: Jeck, Anton, Dipl.-Ing.

(56) Entgegenhaltungen:
- EP-A- 0 025 953
- DE-A- 3 539 404
- DE-A- 3 716 828

## Beschreibung

Die Erfindung betrifft eine Vorrichtung zum elektrisch leitenden Verbinden einer in die Aufnahmenut einer Führungsschiene eingeschobenen Leiterplatte, mit einer, die Führungsschiene tragenden Modulschiene eines Baugruppenträgers, wobei die Leiterplatte in dem von der Aufnahmenut umschlossenen Randbereich mindestens einseitig eine Massegleiterbahn trägt, wobei die Aufnahmenut der Führungsschiene einen Kontaktbügel aufnimmt, der den Rand der Leiterplatte zumindest teilweise umschließend aufnimmt, und wobei der Kontaktbügel aus der Aufnahmenut geführt und mit der Modulschiene elektrisch leitend verbindbar ist.

Bei einem Baugruppenträger verlaufen die aus Metall bestehenden Modulschienen quer zur offenen Vorderseite, von der aus die Leiterplatten eingeschoben werden. Die Leiterplatten sind in zwei U-förmigen Führungsschienen geführt, die eine Aufnahmenut für die Randbereiche der Leiterplatte bilden.

Diese Führungsschienen bestehen in der Regel aus Kunststoff. Bei dieser Materialwahl bereitet es Schwierigkeiten, die Leiterplatte zu erden, d.h. mit dem Chassis des Baugruppenträgers z.B. mit der Modulschiene elektrisch leitend zu verbinden.

Aus der DE 35 39 404 A1 ist eine Führungsschiene bekannt, die mit einer Modulschiene eines Baugruppenträgers verbindbar ist. In die Führungsschiene ist eine Aufnahmenut eingebracht, die in Teilabschnitten verbreitert ist und Aufnahmeschlitze bildet. Die Aufnahmeschlitze sind sowohl zur Vorderseite der Führungsschiene als auch zu deren Rückseite hin geöffnet. In die Aufnahmeschlitze können Kontaktfedern eingesetzt werden, die untereinander mittels eines Blechstreifens miteinander verbunden sind. Die Kontaktfedern dienen zur Kontaktierung der Leiterplatte, wobei zwei jeweils einander gegenüberliegende Kontaktbügel die Leiterplatte klemmen. Mittels den Blechstreifen angeformter Kontaktösen können die Kontaktbügel mit der Modulschiene elektrisch leitend verbunden werden. Hierzu werden Schrauben in die Kontaktösen eingeführt und in die Modulschiene eingeschraubt.

Für die Befestigung und die Kontaktierung der Führungsschiene und der Kontaktfedern ist man somit auf Schraubenaufnahmen in der Modulschiene angewiesen.

Aus der EP 0 025 953 A1 ist ein Klemmblock für Leiterplatten bekannt. Der Klemmblock weist eine Aufnahmenut auf, in die einander gegenüberliegende Klemmfedern eingesetzt sind. Zwischen den Klemmfedern können Leiterplatten geklemmt und kontaktiert werden. Die Klemmfedern selbst sind an einer Kontaktanordnung angeformt. Die Kontaktanordnung weist Rastbügel auf, die eine Modulschiene rastend hintergreifen.

Es ist Aufgabe der Erfindung, eine Vorrichtung der eingangs erwähnten Art zu schaffen, bei der die Kontaktierung des Kontaktbügels mit der Modulschiene eindeutig und sicher außerhalb der Aufnahmenut möglich und bei der der Kontaktbügel fest mit der Führungsschiene verbunden ist.

Die Aufgabe der Erfindung wird durch die im kennzeichnenden Teil des neuen Anspruches 1 angegebenen Merkmale gelöst.

Demnach ist vorgesehen, daß die Leiterplatte an ihrem Randbereich von einem U-förmigen Bügelteil umgriffen ist. An den Seitenschenkeln des Bügelteils sind Kontaktfedern angebracht, die die Leiterplatte klemmen und sicher kontaktieren. An einem Seitenschenkel des Bügelteils ist ein Verbindungsteil angeschlossen, das einen Seitenschenkel der Führungsschiene übergreift und fest mit einem Seitenabsatz der Führungsschiene verbunden ist. Dadurch ist der Kontaktbügel unverlierbar an der Führungsschiene gehalten. Die sichere Kontaktierung mit der Modulschiene erfolgt über Kontaktfedern, eine Kontaktspitze und/oder über Kontaktansätze, die an das Verbindungsteil angeformt sind. Sie kontaktieren die Modulschiene außerhalb der Aufnahmenut.

Nach einer Ausgestaltung ist vorgesehen, daß sich der Kontaktbügel an die Innenwandungen der Aufnahmenut anlegt, und daß die Kontaktfeder sich in Einschubrichtung der Leiterplatte entlang der Seitenschenkel der Führungsschiene erstrecken und federnd ausgebildet sind.

Die Kontaktfedern beeinträchtigen das Einschieben der Leiterplatte in die Führungsschiene nicht, bringen aber eine entsprechende Kontaktkraft auf, wenn sie bei Einschieben der Leiterplatte in Richtung zu den zugekehrten Seitenwänden der Aufnahmenut der Führungsschiene ausgelenkt werden.

Ist vorgesehen, daß das Verbindungsteil mit seinem Anfangsabschnitt an der Außenseite des übergriffenen Seitenschenkels der Führungsschiene und der Endabschnitt an der vertikalen Außenseite des Seitenansatzes der Führungsschiene anliegen, dann sitzt der Kontaktbügel anliegend an der Führungsschiene.

Eine erste Verbindungsmöglichkeit wird dadurch geschaffen, daß der Endabschnitt des Verbindungsteils direkt in den Kontaktansatz ausläuft, der sich federnd auf der Teilerleiste abstützt.

Für die Verbindung des Kontaktbügels mit der Modulschiene ist dagegen vorgesehen, daß an dem Endabschnitt des Verbindungsteils eine Kontaktfeder angeformt ist, die parallel zur vertikalen Außenseite des Seitenansatzes der Führungsschiene ausgerichtet ist und sich in Einschubrichtung der Leiterplatte erstreckt, und daß sich die Kontaktfeder mit einer seitlich angeformten Kontaktspitze außerhalb einer nach oben offenen Aufnahmenut für die Teilerleiste federnd auf der Modulschiene abstützt.

Die Erfindung wird anhand einer Teilansicht im Bereich der Modulschiene und des zugekehrten Endes der Führungsschiene näher erläutert.

Die Ansicht zeigt einen Abschnitt der Modulschiene 10, die z.B. an der Vorderseite eines Baugruppenträgers quer verläuft und dem unteren Randbereich von einschiebbaren Leiterplatten zugeordnet ist. Die Modulschiene 10 ist ein Profilabschnitt, der zur Vorderseite hin eine offene Aufnahmenut 11 und eine zur Oberseite hin offene Aufnahmenut 12 bildet. In die Aufnahmenut 11 wird eine nicht dargestellte Gewindelochleiste eingeschoben, die zur Verbindung der Frontplatten der Leiterplatten oder Leiterplatten-Einschübe dient. Die Aufnahmenut 12 nimmt die Teilerleiste 13 auf, die mit den Teileransätzen 15 die Teilung für die mit der Modulschiene 10 verbindbaren Führungsschienen 20 festlegt. Die Modulschiene 10 besteht aus Metall und ist elektrisch leitend mit dem gesamten Baugruppenträger und dem den Baugruppenträger aufnehmenden Schaltschrank oder dgl. verbunden.

Die Führungsschiene 20 mit ihren Seitenschenkeln 21 und 22 hat U-förmigen Querschnitt und bildet die Aufnahmenut 24 für den Randbereich der Leiterplatte. Im Verbindungsbereich mit der Modulschiene 10 trägt die Führungsschiene 20 den Kontaktbügel 30, der über der Führungsschiene 20 noch einmal einzeln dargestellt ist. Der Kontaktbügel 30 weist ein Bügelteil auf, das den Innenwänden der Aufnahmenut 24 folgt, daran anliegt und den Randbereich der eingeschobenen Leiterplatte beidseitig umschließt. Von dem Bügelteil gehen die beiden Kontaktfedern 31 und 32 aus, die an den Seitenschenkeln des Bügelteils angeformt sind und sich in Einschubrichtung der Leiterplatte erstrecken. Die Kontaktfedern 31 und 32 sind federnd ausgebildet und stützen sich mit ihren freien Enden an den zugekehrten Innenwänden der Seitenschenkel 21 und 22 der Führungsschiene 20 ab, so daß durch die Auslenkung der mittleren Bereiche der Kontaktfedern 31 und 32 beim Einschieben der Leiterplatte eine ausreichende Kontaktkraft erreicht wird. Der Kontaktbügel 30 stellt so eine eindeutige elektrische Verbindung mit der Masseleiterbahn der eingeschobenen Leiterplatte her. Die Modulschiene 10 trägt stirnseitige Gewindebohrungen 14, die die Verbindung mit den Seitenteilen des Baugruppenträgers erleichtern.

Der Kontaktbügel 30 ist fest mit dem Befestigungsende der Führungsschiene 20 verbunden. Dabei spielt es keine Rolle, wie die Führungsschiene 20 mit der Modulschiene 10 verbunden wird. Hier kann eine Rastverbindung ausreichend sein. An dem Seitenschenkel des Kontaktbügels 30 mit der Kontaktfeder 32 ist ein Z-förmiger Verbindungsteil angeformt, der den Seitenschenkel 22 der Führungsschiene 20 übergreift und mit dem Anfangsabschnitt 33 an der Außenseite des Seitenschenkels 22 anliegt. Der Mittelabschnitt 34 des Verbindungsteils stützt sich auf dem Seitenansatz 23 der Führungsschiene 20 ab und ist fest mit diesem verbunden, wie die Befestigungsstelle 38 zeigt. Der Endabschnitt 35 des Verbindungsteils liegt an der vertikalen Außenseite des Seitenansatzes 23 an und läuft direkt in den Kontaktansatz 39 aus, der sich unter Spannung elektrisch leitend auf einem Teileransatz 15 der Teilerleiste 13 abstützt. Außerdem ist an dem Endabschnitt 35 des Verbindungsteils die Kontaktfeder 36 angeformt, die sich an der vertikalen Außenseite des Seitenansatzes 23 entlang in Einschubrichtung der Leiterplatte, d.h. zur Rückseite des Baugruppenträgers hin, erstreckt. Die untere Kante der Kontaktfeder 36 läuft am freien Ende in die Kontaktspitze 37 aus, die sich unter Spannung elektrisch leitend auf der Teilfläche 16 der Modulschiene 10 abstützt. Damit steht der Kontaktbügel 30 sowohl mit der Modulschiene 10, als auch mit der Teilerleiste 13 in gut leitender elektrischer Verbindung, so daß zwischen der Masseleiterbahn der Leiterplatte und dem Baugruppenträger eine durchgehende eindeutige elektrische Verbindung besteht. Der Kontaktbügel 30 ist fest mit der Führungsschiene 20 verbunden und kann daher nicht verloren gehen. Auf diese Weise kann nur eine Führungsschiene 20 oder beide Führungsschienen 20 einer Leiterplatte mit einem Kontaktbügel 30 versehen sein.

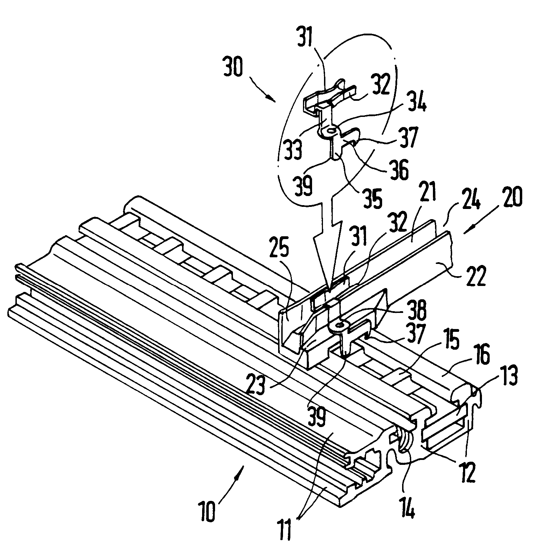

## Patentansprüche

1. Vorrichtung zum elektrisch leitenden Verbinden einer in die Aufnahmenut einer Führungsschiene eingeschobenen Leiterplatte, mit einer, die Führungsschiene tragenden Modulschiene eines Baugruppenträgers, wobei die Leiterplatte in dem von der Aufnahmenut (24) umschlossenen Randbereich mindestens einseitig eine Masseleiterbahn trägt, wobei die Aufnahmenut der Führungsschiene einen Kontaktbügel (30) aufnimmt, der den Rand der Leiterplatte zumindest teilweise umschließend aufnimmt, und wobei der Kontaktbügel aus der Aufnahmenut geführt und mit der Modulschiene elektrisch leitend verbindbar ist,
dadurch gekennzeichnet,
daß der Kontaktbügel, der im Befestigungsbereich mit der Modulschiene in der Aufnahmenut aufgenommen ist, ein U-förmiges Bügelteil aufweist,
daß an den beiden Seitenschenkeln des Bügelteils jeweils eine Kontaktfeder (31,32) angeformt ist, und
daß sich an einen Seitenschenkel des Bügelteils ein einen Seitenschenkel (22) der Führungsschiene (20) übergreifendes Verbindungsteil anschließt, dessen Mittelabschnitt (34) fest mit einem Seitenansatz (23) der Führungsschiene (20) verbunden ist und dessen Endabschnitt (35) eine Kontaktfeder (36), eine Kontaktspitze (37) und/oder mindestens einen Kontaktansatz (39) trägt.

2. Vorrichtung nach Anspruch 1,
dadurch gekennzeichnet,
daß sich der Kontaktbügel (30) an die Innenwandungen der Aufnahmenut (24) anlegt, und
daß die beiden, an den Seitenschenkeln angeformten Kontaktfedern (31,32) sich in Einschubrichtung der Leiterplatte entlang der Seitenschenkel (21,22) der Führungsschiene (20) erstrecken und federnd ausgebildet sind.

3. Vorrichtung nach Anspruch 1 oder 2,
dadurch gekennzeichnet,
daß das Verbindungsteil Z-förmig ist und mit seinem Anfangsabschnitt (33) an der Außenseite des übergriffenen Seitenschenkels (22) der Führungsschiene (20) und mit seinem Endabschnitt an der vertikalen Außenseite des Seitenansatzes (23) der Führungsschiene (20) anliegt.

4. Vorrichtung nach einem der Ansprüche 1 bis 3,
dadurch gekennzeichnet,
daß der Endabschnitt (35) des Verbindungsteils direkt in den Kontaktansatz (39) ausläuft, der sich federnd auf einer Teilerleiste (13) abstützt.

5. Vorrichtung nach einem der Ansprüche 1 bis 4,
dadurch gekennzeichnet,
daß an dem Endabschnitt (35) des Verbindungsteils eine Kontaktfeder (36) angeformt ist, die parallel zur vertikalen Außenseite des Seitenansatzes (23) der Führungsschiene (20) ausgerichtet ist und sich in Einschubrichtung der Leiterplatte erstreckt, und
daß sich die Kontaktfeder (36) mit einer seitlich angeformten Kontaktspitze (37) außerhalb einer nach oben offenen Aufnahmenut (12) für die Teilerleiste (13) federnd auf der Modulschiene (10) abstützt.

## Claims

1. Device for electrically connecting a printed-circuit board inserted in a supporting groove of a guide rail to a modular rack rail supporting the guide rail, the said board being provided atleast at one side with an earth connection track, the said groove receiving a contact clamp (30) which receives the edge of the board and encloses that edge atleast partly, and the contact clamp being led out of the groove and electrically connectabel to the modular rack rail, **characterized** in that
the contact clamp (30) received in the fixing area with the modular rack rail (10) in the groove (24) is provided with an U-shaped clamp part,
each of the two side legs of the clamp part is integral with a contact spring (31, 32) and
a connection part joins one of the side legs of the clamp part, said connection part surrounding one side leg (22) of the guide rail (20), the mean part (34) of the connection part being rigidly connected to a laterally protruding part (23)of the guide rail (20) and the end part (35) of the connection part being provided with a contact spring (36), a contact peak (37) and/or a contacting protruding part (39).

2. Device as claimed in claim 1, characterized in that
the contact clamp (30) is fitted to the inner walls of the receiving groove (24) and
the two contact springs (31, 32) being integral with the side legs extend along the side legs (21, 22) of the guide rail (20) in the insertion direction of the board and are formed as springs.

3. Device as claimed in claim 1 or 2, characterized in that
the connection part is Z-shaped,
the initial part (33) of the connection part is fitted to the outside of the surrounded side leg (22) of the guide rail (20) and
the end part of the connection part is fitted to the vertical outside of the laterally protruding part (23) of the guide rail (20).

4. Device as claimed in any of the claims 1 to 3,
characterized in that the end part (35) of the connection part extends directly to the contacting protruding part (39) resting springably on a sectional strip (13).

5. Device as claimed in any of the claims 1 to 4,
characterized in that a contact spring (36) is integral with the end part (35) of the connection part, the contact spring being directed parallel to the vertical outside of the latarally protruding part (23) of the guide rail (20) and extending in the insertion direction of the board and that a laterally integrated contact peak (37) of the contact spring (36) rests springably on the modular rack rail (10) outside of an upwards opened receiving groove (12) for the sectional strip (13).

## Revendications

1. Dispositif pour relier électriquement une plaque de circuit introduite par glissement dans la rainure de réception d'un rail de guidage avec un rail modulaire d'un rack, rail modulaire qui porte le rail de guidage, dispositif dans lequel la plaque de circuit, dans la zone marginale circonscrite par la rainure de réception (24), porte au moins d'un côté un conducteur de masse, dispositif dans lequel la rainure de réception du rail de guidage reçoit un étrier de contact (30), qui reçoit en le circonscrivant au moins partiellement le bord de la plaque de circuit, et dans lequel l'étrier de contact émerge de la rainure de réception et peut être connecté électriquement au rail modulaire,
caractérisé
en ce que l'étrier de contact, qui est logé dans la rainure de réception au niveau de la zone de fixation avec le rail modulaire, présente une portion d'étrier en forme de U, en ce que sur chacune des deux ailes latérales de la portion d'étrier est formée une lame élastique de contact (31, 32), et
en ce qu'à une aile latérale de la portion d'étrier se raccorde un élément de liaison enveloppant une aile latérale (22) du rail de guidage (20), élément de liaison dont le tronçon médian (34) est relié rigidement à un épaulement latéral (23) du rail de guidage (20) et dont le tronçon terminal (35) porte une lame de contact (36), une pointe de contact (37) et/ou au moins un épaulement de contact (39).

2. Dispositif suivant la revendication 1,
caractérisé
en ce que l'étrier de contact (30) s'applique contre les parois intérieures de la rainure de réception (24), et en ce que les deux lames de contact (31, 32) formées sur les ailes latérales s'étendent dans la direction d'introduction par glissement de la plaque de circuit le long des ailes latérales (21, 22) du rail de guidage (20) et sont élastiques.

3. Dispositif suivant la revendication 1 ou la revendication 2,
caractérisé
en ce que l'élément de liaison est en forme de Z et est par son tronçon initial (33) appliqué sur la paroi extérieure de l'aile latérale (22) enveloppée du rail de guidage (20) et est par son tronçon terminal appliqué sur la paroi extérieure verticale de l'épaulement latéral (23) du rail de guidage (20).

4. Dispositif suivant l'une quelconque des revendications de 1 à 3,
caractérisé
en ce que le tronçon terminal (35) de l'élément de liaison se termine directement par l'épaulement de contact (39) qui s'appuie de manière élastique sur une tringle de division (13).

5. Dispositif suivant l'une quelconque des revendications de 1 à 4,
caractérisé
en ce que sur le tronçon terminal (35) de l'élément de liaison est formée une lame de contact (36) qui est orientée parallèlement à la paroi extérieure verticale de l'épaulement latéral (23) du rail de guidage (20) et qui s'étend dans la direction de l'introduction à glissement de la plaque de circuit, et
en ce que la lame de contact (36), par l'intermédiaire d'une pointe de contact (37) formée latéralement située en dehors d'une rainure de réception (12) ouverte en haut destinée à la tringle de division (13), s'appuie de manière élastique sur le rail modulaire (10).
